# EUROPÄISCHE PATENTANMELDUNG

(11) **EP 1 633 047 A2**
(43) Veröffentlichungstag der Anmeldung: **08.03.2006**
(21) Anmeldenummer: 05019037.0
(22) Anmeldetag: 01.09.2005
(51) Int. Cl.: H03K 17/96

(54) **Berührungsempfindlicher Tastschalter**

(30) Priorität: 03.09.2004 DE 102004042657; 23.03.2005 DE 202005004687 U
(71) Anmelder: Diehl AKO Stiftung & Co. KG, 88239 Wangen (DE)
(72) Erfinder: Arnold, Georg, 91126 Schwabach (DE); Schildbach, Joachim, 63843 Niedernberg (DE); Grundl, Peter, 90491 Nürnberg (DE); Otto, Michael, 90530 Wendelstein (DE)
(74) Vertreter: Diehl Patentabteilung

(57) **Zusammenfassung**

Es wird ein berührungsempfindlicher Tastschalter (10) zum Beispiel für eine Bedienungseinrichtung eines elektronischen Haushaltsgeräts vorgeschlagen, der mehrere elektromagnetische Strahlung aussendende Sendern (12, 13) und mehrere elektromagnetische Strahlung empfangende Empfängern (14) aufweist, die abwechselnd entlang eines geraden oder kreisförmigen Bedienfeldes (22) hinter einer für die elektromagnetische Strahlung zumindest teildurchlässigen Abdeckung (20) angeordnet sind. Die mehreren Sender (12, 13) sind in wenigstens zwei Gruppen mit einer Steuer- und Auswerteeinheit (18) derart verbunden, dass benachbarte Sender (12, 13) jeweils zu unterschiedlichen Gruppen gehören, und die Steuer- und Auswerteeinheit (18) steuert die Sender (12, 13) der wenigstens zwei Gruppen zeitlich versetzt an und vergleicht die zeitlich versetzten Empfangssignale der Empfänger (14) miteinander, um die Position zum Beispiel eines Fingers auf dem Bedienfeld (22) zu bestimmen.

## Beschreibung

Die vorliegende Erfindung betrifft einen berührungsempfindlichen Tastschalter, und insbesondere einen berührungsempfindlichen Tastschalter, der für eine Bedienungseinrichtung eines elektronischen Haushaltsgeräts einsetzbar ist, nach dem Oberbegriff des Anspruchs 1.

Der grundsätzliche Aufbau und das Grundprinzip eines berührungsempfindlichen Tastschalters sind zum Beispiel aus der DE 40 07 971 A1 bekannt. Der berührungsempfindliche Tastschalter weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind. Eine vorteilhafte Anwendung derartiger berührungsempfindlicher Tastschalter ist zum Beispiel der Einsatz in Bedienungseinrichtungen von Haushaltsgeräten, wie Kochherden, Glaskeramik-Kochfeldern, Mikrowellenherden und dergleichen, bei denen der Tastschalter, damit er einfach zu bedienen und auch zu reinigen ist, hinter einer Abdeckung, wie beispielsweise einer Glasplatte oder Glaskeramikplatte angeordnet ist.

Für verschiedene Bedienfunktionen eines elektronischen Haushaltsgeräts sind so genannte Schieberegler von Vorteil, mit denen der Benutzer in analoger Weise einen beliebigen Stellwert zwischen einem Minimalwert und einem Maximalwert eingeben kann. Ein derartiger analoger Schieberegler in der Ausführungsform eines berührungsempfindlichen Tastschalters der oben beschriebenen Art ist noch nicht bekannt. Es besteht deshalb Bedarf an einem solchen berührungsempfindlichen Tastschalter, da diese einfacher zu bedienen und zu reinigen sind und in optisch ansprechender Weise in eine Bedienungseinrichtung eines modernen Haushaltsgeräts zu integrieren sind.

Der vorliegenden Erfindung liegt daher die Aufgabe zugrunde, einen berührungsempfindlichen Tastschalter der eingangs genannten Art derart weiterzuentwickeln, dass er bei einfachem Aufbau und mit möglichst wenig Bauteilen in der Art eines Schiebereglers zu betätigen ist.

Diese Aufgabe wird gelöst durch einen berührungsempfindlichen Tastschalter mit den Merkmalen des Anspruchs 1. Vorteilhafte Ausgestaltungen und Weiterbildungen der Erfindung sind Gegenstand der abhängigen Ansprüche.

Der berührungsempfindliche Tastschalter der Erfindung weist mehrere elektromagnetische Strahlung aussendende Sendern und mehrere elektromagnetische Strahlung empfangende Empfängern, die abwechselnd entlang eines Bedienfeldes hinter einer für die elektromagnetische Strahlung zumindest teildurchlässigen Abdeckung angeordnet sind, sowie eine Steuer- und Auswerteeinheit, die mit den mehreren Sendern und Empfängern verbunden ist, zum Ansteuern der mehreren Sender und Auswerten der Empfangssignale der mehreren Empfänger auf und ist erfindungsgemäß dadurch gekennzeichnet, dass die mehreren Sender in wenigstens zwei Gruppen mit der Steuer- und Auswerteeinheit derart verbunden sind, dass benachbarte Sender jeweils zu unterschiedlichen Gruppen gehören, und dass die Steuer- und Auswerteeinheit die Sender der wenigstens zwei Gruppen zeitlich versetzt ansteuert und die zeitlich versetzten Empfangssignale der Empfänger miteinander vergleicht, um die Position eines Betätigungselements auf dem Bedienfeld zu bestimmen.

Durch das Vorsehen mehrerer Sender und Empfänger entlang eines Bedienfeldes und das Vergleichen der Empfangssignale der Empfänger miteinander, ist es auf einfache Weise möglich, die Position zum Beispiel eines Fingers auf dem Bedienfeld in quasi analoger Weise mit einer guten Auflösung zu bestimmen. Aufgrund der zeitlich versetzten Ansteuerung von wenigstens zwei Sendergruppen erhält man von einem Empfänger zwei Empfangssignale, die miteinander verglichen werden können, sodass die Anzahl der erforderlichen Empfänger deutlich reduziert werden kann. Außerdem muss wegen der wenigstens zwei Sendergruppen nur jeweils ein Empfänger empfangsbereit sein, d.h. ein Überstrahlen der übrigen Empfänger durch zum Beispiel Fremdlicht ist für die Eingabe eines Stellwerts unschädlich.

Vorzugsweise ist die elektromagnetische Strahlung eine Infrarot-Strahlung.

Das Bedienfeld kann sowohl geradlinig sein als auch eine geschlossene Kurvenform (z.B. kreisförmig oder oval) bilden.

In einer Ausführungsform der Erfindung vergleicht die Steuer- und Auswerteeinheit die relativen Intensitätsniveaus der zeitlich versetzten Empfangssignale der Empfänger miteinander. Mit anderen Worten bestimmt die Steuer- und Auswerteeinheit, welches von zwei Empfangssignalen ein höheres Intensitätsniveau aufweist, um daraus die grobe Position zum Beispiel eines Fingers auf dem Bedienfeld zu bestimmen. Diese relativ grobe Auswertung der Empfangssignale ist in vielen Fällen ausreichend, in denen über den Tastschalter nur einige wenige vorgegebene Steilwerte eingebbar sein sollen.

In einer weiteren Ausführungsform der Erfindung vergleicht die Steuer- und Auswerteeinheit die absoluten Intensitätsniveaus der zeitlich versetzten Empfangssignale der Empfänger miteinander. Falls dieser Vergleich der absoluten Intensitätsniveaus sogar unter Verwendung einer Quotientenbildung erfolgt, so sind grundsätzlich Stellwerte mit einer sehr feinen Auflösung eingebbar, sodass ein quasi-analoger Schieberegler mit beliebigen Zwischenwerten realisierbar ist. Der Verwendung des Quotienten der absoluten Intensitätsniveaus hat den Vorteil, dass die Positionsbestimmung nicht von den erfassten Absolutwerten selbst abhängt.

Eine besonders vorteilhafte Ausführungsform der Erfindung wird erreicht, wenn die Sender einerseits und die Empfänger andererseits auf unterschiedlichen Seiten des Bedienfeldes (bei einem geradlinigen Bedienfeld insbesondere oberhalb und unterhalb oder bei einem Bedienfeld mit einer geschlossenen Kurvenform insbesondere außerhalb oder innerhalb) angeordnet sind, wobei weiterhin vorgesehen sein kann, dass die Sender und Empfänger zumindest teilweise auf Lücke gegeneinander angeordnet sind. Dabei können die Abstände zwischen Sendern der ersten und der zweiten Gruppe und/oder die Abstände zwischen zwei Empfängern im Bereich von Tastfeldern niedriger Kochstufen geringer sein als im Bereich von Tastfeldern hoher Kochstufen. Darüber hinaus kann zusätzlich vorgesehen sein, dass im Bereich des Tastfeldes für die Kochstufe 0 und/oder im Bereich des Tastfeldes für die Kochstufe 9 ein Sender und ein Empfänger genau einander gegenüberliegen.

Der berührungsempfindliche Tastschalter der Erfindung ist vorteilhafterweise in einer Bedienungseinrichtung für ein elektronisches Haushaltsgerät einsetzbar. Dabei kann dem Tastschalter ferner eine Anzeigevorrichtung zugeordnet sein, mit welcher dem Benutzer der über das Bedienfeld eingegebene Stellwert des Tastschalters angezeigt wird, um die Eingabe eines gewünschten Stellwerts zu vereinfachen.

Obige sowie weitere Merkmale und Vorteile der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen:
- Fig. 1: eine stark vereinfachte schematische Seitenansicht eines berührungsempfindlichen Tastschalters gemäß der vorliegenden Erfindung zur Erläuterung des Grundaufbaus;
- Fig. 2: eine Draufsicht eines Ausführungsbeispiels einer Bedienungseinrichtung mit einem berührungsempfindlichen Tastschalter gemäß der vorliegenden Erfindung;
- Fig. 3: eine stark vereinfachte schematische Seitenansicht eines berührungsempfindlichen Tastschalters gemäß der vorliegenden Erfindung zur Erläuterung der Funktionsweise;
- Fig. 4: eine schematische Draufsicht eines Ausführungsbeispiels eines berührungsempfindlichen Tastschalters gemäß der vorliegenden Erfindung;
- Fig. 5A und 5B: eine tabellarische bzw. graphische Darstellung der Intensitätsniveaus der Empfangssignale zur Erläuterung der Funktionsweise der vorliegenden Erfindung; und
- Fig. 6: eine schematische Draufsicht eines weiteren Ausführungsbeispiels der Erfindung.

Unter Bezugnahme auf die beiliegenden Zeichnungen werden nun der Grundaufbau, die Funktionsweise und verschiedene Ausführungsformen eines berührungsempfindlichen Tastschalters der Erfindung im Detail beschrieben.

Der berührungsempfindliche Tastschalter der Erfindung ist zum Beispiel ein Infrarot-Tastschalter für eine Bedienungseinrichtung eines elektronischen Haushaltsgeräts, wie beispielsweise eines Kochherdes, eines Mikrowellenherdes, eines Kochfeldes, einer Waschmaschine, eines Wäschetrockners, einer Spülmaschine oder dergleichen, ohne dass die Erfindung auf eine elektromagnetische Strahlung dieses Wellenlängenbereichs oder diese spezielle Anwendung beschränkt ist.

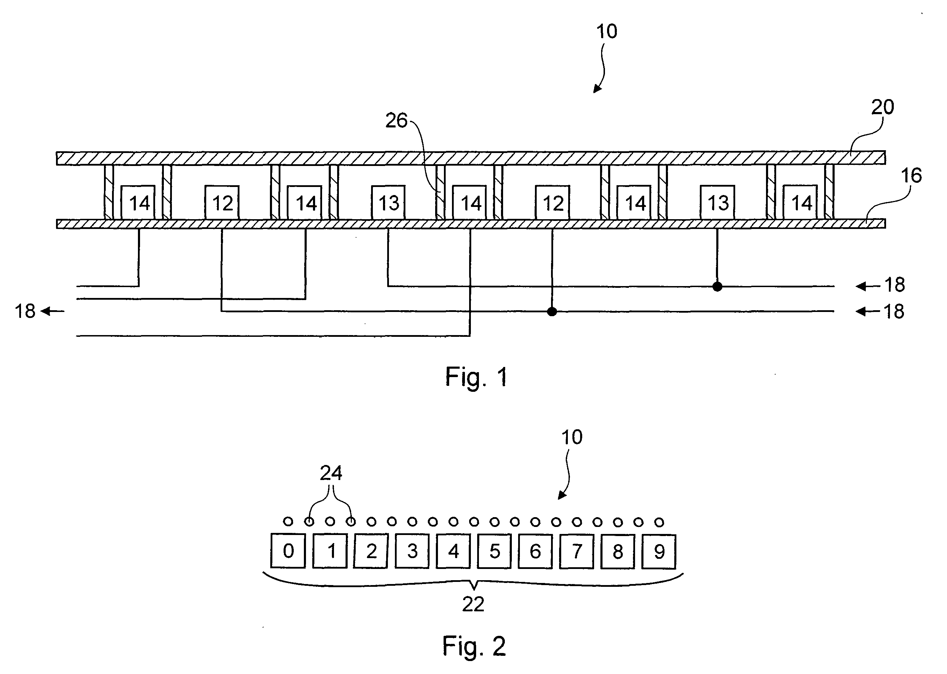

Wie in Fig. 1 und 2 dargestellt, weist der Infrarot-Tastschalter 10 mehrere Infrarot-Sender 12, 13 und mehrere Infrarot-Empfänger 14 auf, die abwechselnd entlang eines Bedienfeldes 22 hinter einer für die Infrarot-Strahlung zumindest teildurchlässigen Abdeckung 20 auf einer Platine 16 angeordnet sind. Um eine Störung des Empfangssignals der Empfänger 14 durch eine Infrarot-Strahlung, die von den Sendern 12, 13 direkt auf die Empfänger 14 fällt, zu verhindern, sind die Empfänger bevorzugt mit einer geeigneten Abschottung bzw. Blende 26 versehen.

Zur Auswertung der Empfangssignale der Empfänger 14 sind die Empfänger 14 mit einer (nicht dargestellten) Steuer- und Auswerteeinheit 18 verbunden. Die Sender 12, 13 sind ebenfalls mit der Steuer- und Auswerteeinheit 18 verbunden, wobei die Sender 12, 13 in wenigstens zwei Gruppen (z.B. Sender 12 der ersten Gruppe und Sender 13 der zweiten Gruppe) mit der Steuer- und Auswerteeinheit 18 derart verbunden sind, dass jeweils zwei benachbarte Sender 12, 13 einer unterschiedlichen Sendergruppe zugeordnet sind. Die Steuer- und Auswerteeinheit 18 steuert die den verschiedenen Sendergruppen zugeordneten Sender 12 und 13 zeitlich versetzt an.

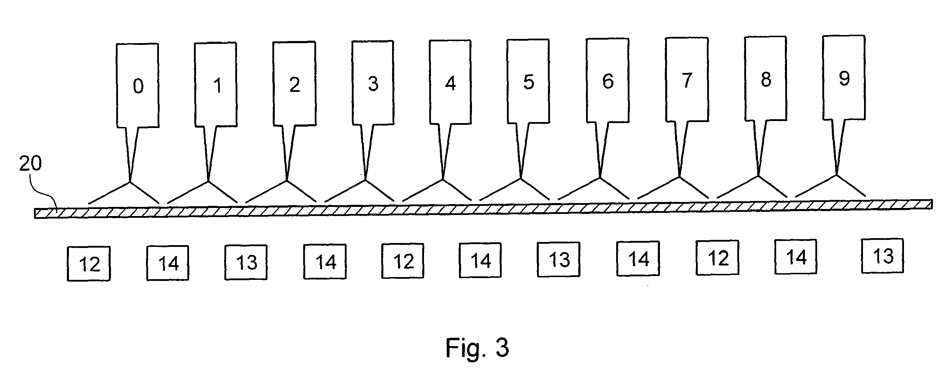

Wie in Fig. 3 schematisch veranschaulicht, ist mit einem derart aufgebauten Infrarot-Tastschalter 10 mit insgesamt nur fünf Empfängern 14 und sechs Sendern 12, 13, die entlang eines geradlinigen Bedienfeldes 22 abwechselnd angeordnet sind, zum Beispiel die Eingabe von zehn Stellwerten 0...9 möglich. Hierzu ist es lediglich erforderlich, dass die Steuer- und Auswerteeinheit 18 die relativen Intensitätsniveaus der zeitlich versetzten Empfangssignale miteinander zu vergleichen, um zu bestimmen, welches Empfangssignal das höchste Intensitätsniveau aufweist, und daraus die grobe Position 0...9 zum Beispiel eines Fingers auf dem Bedienfeld 22 zu ermitteln.

Der auf diese Weise eingegebene Stellwert wird dem Benutzer vorzugsweise über eine dem Infrarot-Tastschalter 10 zugeordnete Anzeigevorrichtung 24 angezeigt, die zum Beispiel als eine LED-Reihe (siehe Fig. 2) oder eine digitale Anzeige ausgebildet sein kann.

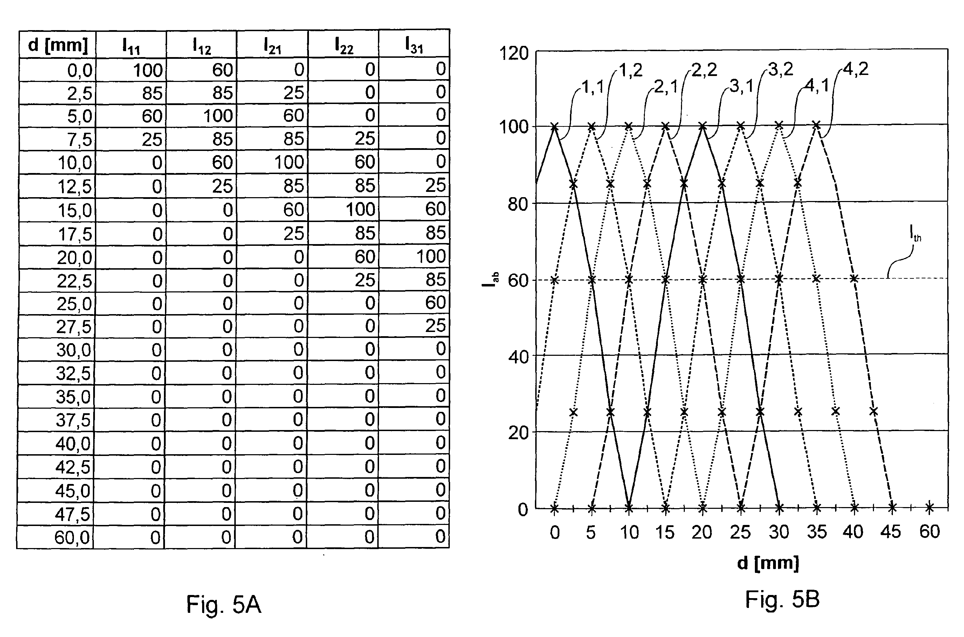

Zur Verdeutlichung des Auswerteverfahrens zeigen Fig. 5A und 5B in tabellarischer bzw. graphischer Form die Intensitätsniveaus I_{ab}, der zeitlich versetzten Empfangssignale b der Empfänger a in Abhängigkeit der Position d eines Fingers auf dem Bedienfeld 22. In dem Ausführungsbeispiel von Fig. 5A und 5B beträgt der regelmäßige Abstand zwischen einem Sender und einem Empfänger 5 mm, der regelmäßige Abstand zwischen benachbarten Empfängern beträgt 10 mm, und der regelmäßige Abstand zwischen benachbarten Sendern beträgt 10 mm.

Ein Wert d = 0,0 mm bedeutet, dass ein Finger an der Position 0 (siehe Fig. 3) zwischen dem ersten Sender 12 der ersten Gruppe und dem ersten Empfänger 14 positioniert ist, sodass das Intensitätsniveau I₁₁ des Empfangssignals des ersten Empfängers 14 als Reaktion auf das am Finger reflektierte Infrarotsignal des ersten Senders 12 hier 100 beträgt, während das Intensitätsniveau I₁₂ des Empfangssignals des ersten Empfängers 14 als Reaktion auf das am Finger reflektierte Infrarotsignal des zweiten Senders 13, der zeitlich versetzt zu dem ersten Sender 12 angesteuert wird, nur 60 beträgt. Durch einen Vergleich dieser relativen Intensitätsniveaus I₁₁ und I₁₂ kann die Steuer- und Auswerteeinheit 18 ermitteln, dass das I₁₁ > I₁₂ und dass daher der Finger irgendwo zwischen dem ersten Sender 12 und dem ersten Empfänger 14 positioniert ist. Werden durch die Steuer- und Auswerteeinheit 18 sogar die absoluten Intensitätsniveaus ausgewertet, so kann die Steuer- und Auswerteeinheit 18 anhand zum Beispiel der Tabelle von Fig. 5A oder einer geeigneten Formel bestimmen, dass für I₁₁ = 100 und I₁₂ = 60 der Finger exakt in der Mitte zwischen dem ersten Sender 12 und dem ersten Empfänger 14 positioniert ist.

Der zuletzt beschriebene Vergleich der absoluten Intensitätsniveaus erfolgt dabei bevorzugt mittels einer Quotientenbildung der beiden Intensitätsniveaus. Wertet man den exakten Quotientenwert aus, so erhält man einen analogen Wert der Position des Fingers auf dem Bedienfeld 22. Die Positionsbestimmung über einen Quotienten der absoluten Intensitätsniveaus hat gegenüber einem direkten Vergleich der absoluten Intensitätsniveaus den entscheidenden Vorteil, dass die Positionsbestimmung durch die Steuer- und Auswerteeinheit 18 von den absoluten Intensitätsniveaus, die u.a. von Fremdlichteinfall, Reflexionseigenschaften der Abdeckung und des Fingers, Alterungserscheinungen der Bauteile, usw. abhängen, unabhängig ist.

Der nächste Wert d = 2,5 mm bedeutet, dass ein Finger genau über dem ersten Empfänger 14 positioniert ist, sodass sowohl das Intensitätsniveau I₁₁ des Empfangssignals des ersten Empfängers 14 als Reaktion auf das am Finger reflektierte Infrarotsignal des ersten Senders 12 als auch das Intensitätsniveau I₁₂ des Empfangssignals des ersten Empfängers 14 als Reaktion auf das am Finger reflektierte Infrarotsignal des zweiten Senders 13 gleichermaßen 85 beträgt. Das Intensitätsniveau I₂₁ des Empfangssignals des zweiten Empfängers 14 als Reaktion auf das am Finger reflektierte Infrarotsignal des ersten Senders 12 beträgt dagegen nur 25, was unterhalb eines Schwellenwerts Iₜₕ für die Erkennbarkeit des Reflexionssignals bei einer Fremdlichteinstrahlung liegt, während das Intensitätsniveau I₂₂ des Empfangssignals des zweiten Empfängers 14 als Reaktion auf das am Finger reflektierte Infrarotsignal des zweiten Senders 13 nicht mehr messbar ist. Durch einen Vergleich der relativen Intensitätsniveaus I₁₁ und I₁₂ kann die Steuer- und Auswerteeinheit 18 ermitteln, dass das I₁₁ = I₁₂ und dass daher der Finger genau über dem ersten Empfänger 14 positioniert ist.

Verschiebt der Benutzer den Finger um weitere 2,5 mm zu einer Position zwischen dem ersten Empfänger 14 und dem zweiten Sender 13, so beträgt das Intensitätsniveau I₁₁ des Empfangssignals des ersten Empfängers als Reaktion auf das am Finger reflektierte Infrarotsignal des ersten Senders 60, das Intensitätsniveau I₁₂ des Empfangssignals des ersten Empfängers als Reaktion auf das am Finger reflektierte Infrarotsignal des zweiten Senders aus der zweiten Sendergruppe beträgt 100, und das Intensitätsniveau I₂₁ des Empfangssignals des zweiten Empfängers als Reaktion auf das am Finger reflektierte Infrarotsignal des ersten Senders aus der ersten Sendergruppe beträgt 60. Durch einen Vergleich der relativen Intensitätsniveaus I₁₁ und I₁₂ oder I₁₂ und I₂₁ kann die Steuer- und Auswerteeinheit 18 ermitteln, dass das I₁₁ < I₁₂ bzw. I₁₂ > I₂₁ und dass daher der Finger irgendwo zwischen dem ersten Empfänger 14 und dem zweiten Sender 13 positioniert ist. Durch Auswertung der absoluten Intensitätsniveaus I₁₁, I₁₂, I₂₁ lässt sich die Position des Fingers wieder exakt bestimmen.

Durch weiteres Verschieben des Fingers entlang des Bedienfeldes 22 lassen sich so bei Auswertung der relativen Intensitätsniveaus der Empfangssignale einfach die Stellwerte 0...9 eingeben, und bei Auswertung der absoluten Intensitätsniveaus der Empfangssignale können die Stellwerte in quasi analoger Weise mit Zwischenwerten bei hoher Genauigkeit bzw. Auflösung eingegeben werden.

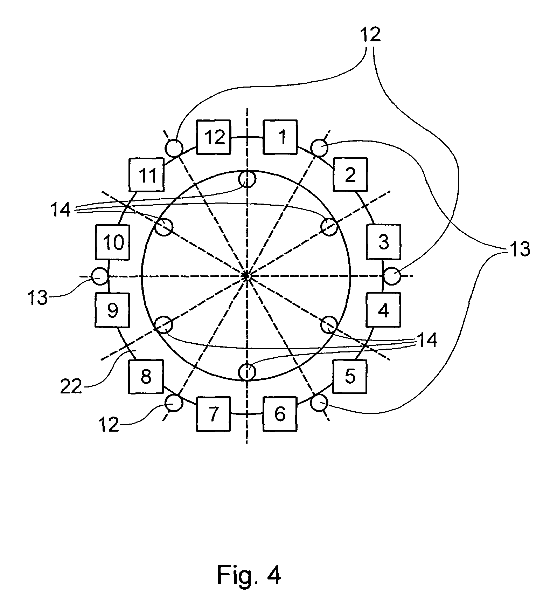

Während oben das Bedienfeld 22 des Infrarot-Tastschalters im Wesentlichen geradlinig ausgebildet ist, ist es alternativ auch möglich, dass das Bedienfeld die Form einer geschlossen Kurve bildet, d.h. zum Beispiel kreisförmig oder oval ausgebildet ist, wie in Fig. 4 veranschaulicht.

In dem Ausführungsbeispiel von Fig. 4 ist das Bedienfeld 22 auf der Abdeckung 20 der Bedienungseinrichtung vorzugsweise optisch gekennzeichnet, um dem Benutzer die Position des Tastschalters anzuzeigen und die Eingabe zu vereinfachen. Die Sender 12, 13 der ersten und der zweiten Sendergruppe sind in Draufsicht außerhalb des kreisförmigen Bedienfeldes 22 angeordnet, während die Empfänger 14 innerhalb des Bedienfeldes 22 angeordnet sind. Selbstverständlich ist aber auch eine andere, z.B. umgekehrte Anordnung der Sender und Empfänger möglich.

Mit nur sechs Empfängern 14 und insgesamt sechs Sendern 12, 13 einer ersten und einer zweiten Sendergruppe können selbst bei der Auswertung nur der relativen Intensitätsniveaus der Empfangssignale einfach zwölf Stellwerte 0...12 eingegeben werden. Bei der Auswertung der absoluten Intensitätsniveaus der Empfangssignale können auch Zwischenwinkelpositionen ermittelt und die Stellwerte somit quasi analog eingegeben werden.

Bei der geschlossenen Kurvenform des Bedienfeldes 22 ist es auch denkbar, einen unendlich langen Schieberegler aufzubauen. Des weiteren ist es denkbar, dass die Steuer- und Auswerteeinheit 18 bei dem ersten Aufsetzen des Fingers an einer Winkelposition über die Anzeigevorrichtung einen Vorschlagswert anzeigt, der dann von dem Benutzer durch Verschiebend des Fingers entlang des Bedienfeldes 22 verändert werden kann.

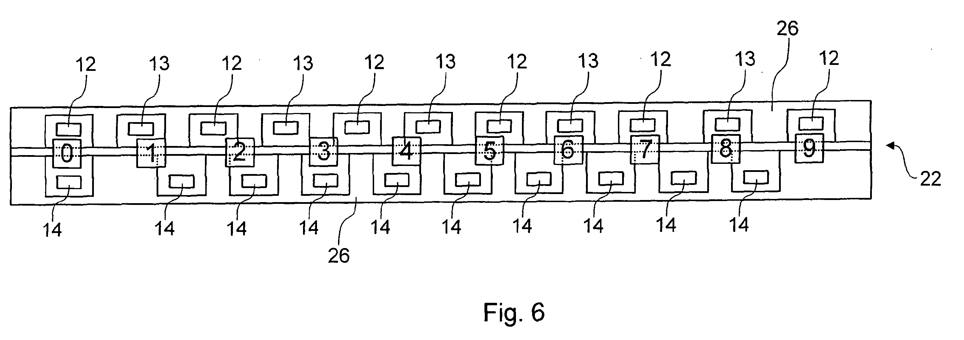

In Figur 6 ist ein weiteres Ausführungsbeispiel des erfindungsgemäßen berührungsempfindlichen Tastschalters gezeigt. Bei dieser Ausführungsform ist das Bedienfeld 22 mit den Tasten für die Kochstufen 1 bis 9 wiederum geradlinig, d. h. linear ausgeführt. Jedoch sind hier die Sender 12, 13 und Empfänger 14 nicht wie bei den Figuren 1 und 3 in einer Linie nebeneinander, sondern knapp oberhalb und knapp unterhalb des eigentlichen Bedienfeldes 22 angeordnet. Außerdem liegen die Sender 12, 13 der ersten und der zweiten Gruppe jeweils abwechselnd in einer Linie nebeneinander oberhalb des Bedienfeldes 22, während die Empfänger 14 - ebenfalls in einer Linie nebeneinander liegend - unterhalb des Bedienfeldes 22 angeordnet sind. Dabei liegen Sender 12, 13 und Empfänger 14 (zumindest für die Kochstufen 1 bis 9) in etwa auf Lücke gegeneinander, so dass ein Sender 12 oder 13 jeweils einer Lücke zwischen zwei Empfängern 14 gegenüberliegt, während ein Empfänger 14 einer Lücke zwischen einem Sender 12 der ersten Gruppe und einem Sender 13 der zweiten Gruppe gegenüberliegt. Durch diese Anordnung wird erreicht, dass bei trotzdem weiterhin kompakter Länge des Bedienfeldes 22 auch eine Einstellung von Zwischenkochstufen wie 2 1 /2 oder 5 1/2 durch Auflegen des Fingers zwischen den jeweiligen Tastfeldern (hier also zwischen 2 und 3 bzw. zwischen 5 und 6) sicher detektiert werden kann.

Um die Detektion von Zwischenkochstufen, die gerade bei den niedrigen Kochstufen gerne vermehrt angewählt werden, noch zu verbessern, ist die Anordnung der Sender 12, 13 und Empfänger 14 im Bereich der niedrigen Kochstufen enger ausgeführt als im Bereich der hohen Kochstufen. Diese bezüglich des Abstandes untereinander nicht lineare Anordnung der Sender 12, 13 und Empfänger 14 wird natürlich bei der Signalauswertung in der Auswerte- und Steuereinheit 18 berücksichtigt, damit bei einer Betätigung der gleichmäßig angeordneten Kochstufenschaltfelder auch tatsächlich die richtige Kochstufe eingeschaltet wird.

Da gerade das Ausschalten einer Kochplatte, d. h. die Einstellung der Kochstufe 0, besonders sicher erkannt werden muss, sind im Bereich des Tastfeldes für die Kochstufe 0 ein Sender 12 und ein Empfänger 14 genau gegenüberliegend angeordnet.

Wie oben beschrieben, ist mit dem erfindungsgemäßen Tastschalter trotz einer geringen Anzahl von Bauteilen eine relativ hohe Auflösung der Positionsbestimmung möglich. Dies ist darin begründet, dass durch die zeitlich versetzte Ansteuerung von benachbarten Sendern 12, 13 von jedem Empfänger 14 zwei Empfangssignale abgeleitet werden können, die von der Steuer- und Auswerteeinheit 18 miteinander verglichen werden. Dies hat den weiteren Vorteil, dass jeweils nur ein Empfänger 14 empfangsbereit sein muss, d.h. nicht durch Fremdlicht überstrahlt sein darf. Bei einem Sender 12, 13 besteht die Problematik einer Überstrahlung durch Fremdlicht dagegen nicht. Durch die Aufteilung der Sender 12, 13 in zwei Sendergruppen kann zum Beispiel die Anzahl der Bauteile gegenüber einem Tastschalter ohne Sendergruppierung, bei dem jeweils zwei Empfänger ausgewertet werden müssen, halbiert werden.

Während in den obigen Ausführungsbeispielen die Sender 12, 13 in eine erste Sendergruppe und eine zweite Sendergruppe aufgeteilt sind, die entlang des Bedienfeldes 22 alternierend angeordnet sind, sodass zwei benachbarte Sender 12, 13 immer unterschiedlichen Sendergruppen angehören, ist die vorliegende Erfindung nicht hierauf beschränkt. So können die Sender 12, 13 auch in drei oder mehr Sendergruppen eingeteilt werden, die von der Steuer- und Auswerteeinheit 18 zeitlich versetzt zueinander angesteuert werden. Grundsätzlich ist auch möglich, dass jede Sendergruppe nur einen Sender umfasst, der einzeln und zeitlich versetzt zu allen übrigen Sendern angesteuert wird.

Im Rahmen der vorliegenden Erfindung ist es auch möglich, dass durch die Steuer- und Auswerteeinheit Zusatzfunktionen, wie beispielsweise Schnelllauf, Langsamlauf, Wertevorgaben und dergleichen, unterstützt werden.

### BEZUGSZIFFERNLISTE

- 10: Tastschalter
- 12: Sender der ersten Gruppe
- 13: Sender der zweiten Gruppe
- 14: Empfänger
- 16: Platine
- 18: Auswerte- und Steuereinheit
- 20: Abdeckung
- 22: Bedienfeld
- 24: Anzeigevorrichtung
- 26: Abschottung

## Patentansprüche

1. Berührungsempfindlicher Tastschalter (10), mit
mehreren elektromagnetische Strahlung aussendenden Sendern (12, 13) und mehreren elektromagnetische Strahlung empfangenden Empfängern (14), die abwechselnd entlang eines Bedienfeldes (22) hinter einer für die elektromagnetische Strahlung zumindest teildurchlässigen Abdeckung (20) angeordnet sind; und
einer Steuer- und Auswerteeinheit (18), die mit den mehreren Sendern und Empfängern verbunden ist, zum Ansteuern der mehreren Sender und Auswerten der Empfangssignale der mehreren Empfänger,
**dadurch gekennzeichnet,**
**dass** die mehreren Sender (12, 13) in wenigstens zwei Gruppen mit der Auswerte- und Steuereinheit (18) derart verbunden sind, dass benachbarte Sender (12, 13) jeweils zu unterschiedlichen Gruppen gehören; und
**dass** die Steuer- und Auswerteeinheit (18) die Sender (12, 13) der wenigstens zwei Gruppen zeitlich versetzt ansteuert und die zeitlich versetzten Empfangssignale der Empfänger (14) miteinander vergleicht, um die Position eines Betätigungselements auf dem Bedienfeld (22) zu bestimmen.

2. Tastschalter nach Anspruch 1,
**dadurch gekennzeichnet,**
**dass** die elektromagnetische Strahlung Infrarot-Strahlung ist.

3. Tastschalter nach Anspruch 1 oder 2,
**dadurch gekennzeichnet,**
**dass** das Bedienfeld (22) geradlinig ist.

4. Tastschalter nach Anspruch 1 oder 2,
**dadurch gekennzeichnet,**
**dass** das Bedienfeld (22) eine geschlossene Kurvenform bildet.

5. Tastschalter nach einem der Ansprüche 1 bis 4,
**dadurch gekennzeichnet,**
**dass** die Steuer- und Auswerteeinheit (18) die relativen Intensitätsniveaus der zeitlich versetzten Empfangssignale der Empfänger (14) miteinander vergleicht.

6. Tastschalter nach einem der Ansprüche 1 bis 4,
**dadurch gekennzeichnet,**
**dass** die Steuer- und Auswerteeinheit (18) die absoluten Intensitätsniveaus der zeitlich versetzten Empfangssignale der Empfänger (14) miteinander vergleicht.

7. Tastschalter nach Anspruch 6,
**dadurch gekennzeichnet,**
**dass** die Steuer- und Auswerteeinheit (18) die absoluten Intensitätsniveaus der zeitlich versetzten Empfangssignale der Empfänger (14) unter Verwendung einer Quotientenbildung miteinander vergleicht.

8. Tastschalter nach einem der vorhergehenden Ansprüche,
**dadurch gekennzeichnet,**
**dass** die Sender (12,13) einerseits und die Empfänger (14) andererseits auf unterschiedlichen Seiten des Bedienfeldes, insbesondere oberhalb und unterhalb oder außerhalb und innerhalb angeordnet sind,
wobei bevorzugt vorgesehen ist, dass die Sender (12,13) und Empfänger (14) zumindest teilweise auf Lücke gegenüberliegen.

9. Tastschalter nach Anspruch 8,
**dadurch gekennzeichnet,**
**dass** die Abstände zwischen Sendern (12,13) der ersten und der zweiten Gruppe und/oder zwischen Empfängern (14) im Bereich von Tastfeldern niedriger Kochstufen geringer sind als im Bereich von Tastfeldern hoher Kochstufen,
wobei vorzugsweise vorgesehen ist, dass im Bereich des Tastfeldes für die Kochstufe 0 und/oder 9 ein Sender (12) und ein Empfänger (14) direkt gegenüberliegend angeordnet sind.

10. Bedienungseinrichtung für ein elektronisches Haushaltsgerät mit wenigstens einem berührungsempfindlichen Tastschalter (10) nach einem der Ansprüche 1 bis 9.

11. Bedienungseinrichtung nach Anspruch 10,
**dadurch gekennzeichnet,**
**dass** dem Tastschalter (10) eine Anzeigevorrichtung (24) zugeordnet ist, mit welcher dem Benutzer der über das Bedienfeld (22) eingegebene Stellwert des Tastschalters angezeigt wird.
